# EUROPEAN PATENT APPLICATION

(11) **EP 4 814 525 A1**
(43) Date of publication of application: **30.09.2026**
(21) Application number: 25166776.2
(22) Date of filing: 27.03.2025
(51) Int. Cl.: G01R 33/483, G01R 33/563, G01R 33/565, G01R 33/567

(54) **ACQUISITION SPECIFIC INTERLEAVED SLICE ORDERING AND TIMING IN MAGNETIC RESONANCE IMAGING**

(71) Applicant: Koninklijke Philips N.V., 5656 AE Eindhoven (NL)
(72) Inventor: PEETERS, Johannes Martinus, Eindhoven (NL); YONEYAMA, Masami, Eindhoven (NL)
(74) Representative: Philips Intellectual Property & Standards

(57) **Abstract**

Methods and systems for performing the methods of magnetic resonance imaging (MRI) are presented. The method of MRI comprises: receiving (200) multiple MRI packages (144,146,148), wherein each MRI package is a grouping of multiple MRI pulse sequence parameters each specifying one or more package specific slices, wherein the multiple MRI pulse sequence parameters are adapted for configuring pulse sequence commands for implementing a physiologically gated MRI protocol; regrouping (202) the multiple MRI packages into interleaved acquisition groups (150,152,154,156) such that the one or more package specific slices for any of the multiple MRI packages is not repeated within each of the interleaved acquisition groups; repeatedly (204) receiving a periodic physiological signal descriptive of a physiological state of a subject; repeatedly (206) acquiring k-space data (158) by controlling the magnetic resonance imaging system with the pulse sequence commands triggered by the periodic physiological signal while sequentially adjusting the pulse sequence commands with the pulse sequence parameters of one of the interleaved acquisition groups; and providing (208) the acquired k-space data.

## Description

### TECHNICAL FIELD

The invention relates to magnetic resonance imaging, in particular to the acquisition of slices in interleaved magnetic resonance imaging.

### BACKGROUND

Magnetic resonance imaging (MRI) is a diagnostic technique that employs magnetic fields and radio frequency energy to generate images of internal structures by exploiting the magnetic properties of hydrogen nuclei in body tissues. Diffusion weighted imaging (DWI) is a specific MRI application that measures the movement of water molecules within tissues, thereby providing information that may be indicative of changes in tissue microstructure associated with various pathological conditions.

### SUMMARY

The invention provides for a medical system, a method of magnetic resonance imaging, and a computer program in the independent claims, embodiments are given in the dependent claims.

In one aspect a medical system comprising a magnetic resonance imaging system is disclosed. The medical system comprises a memory storing machine executable instructions and pulse sequence commands configured for implementing a physiologically gated MRI protocol. The medical system further comprises a computational system. Execution of the machine executable instructions causes the computational system to receive multiple MRI packages. Each MRI package is a grouping of multiple MRI pulse sequence parameters each specifying one or more package specific slices. Execution of the machine executable instructions further causes the computational system to regroup the multiple MRI packages into interleaved acquisition groups such that the one or more package specific slices for any of the multiple MRI packages is not repeated within each of the interleaved acquisition groups.

Execution of the machine executable instructions further causes the computational system to repeatedly receive a periodic physiological signal descriptive of a physiological state of a subject. Execution of the machine executable instructions further causes the computational system to repeatedly acquire k-space data triggered by the periodic physiological signal by controlling the magnetic resonance imaging system with the pulse sequence commands while sequentially adjusting the pulse sequence commands with the pulse sequence parameters of the interleaved acquisition groups. Execution of the machine executable instructions further causes the computational system to provide the acquired k-space data.

In another aspect a method of magnetic resonance imaging is disclosed. The method comprises receiving multiple MRI packages. Each MRI package is a grouping of multiple pulse sequence parameters each specifying one or more package specific slices. The multiple MRI pulse sequence parameters are adapted for configuring pulse sequence commands for implementing a physiologically gated MRI protocol. The method further comprises regrouping the multiple MRI packages into interleaved acquisition groups such that the one or more package specific slices for any of the multiple MRI packages is not repeated within each of the interleaved acquisition groups.

The method further comprises repeatedly receiving a periodic physiological signal descriptive of a physiological state of a subject. The method further comprises repeatedly acquiring k-space data triggered by the periodic physiological signal by controlling the magnetic resonance imaging system with the pulse sequence commands while sequentially adjusting the pulse sequence commands with the pulse sequence parameters of one of the interleaved acquisition groups. The method further comprises providing the acquired k-space data.

In an embodiment the physiologically gated MRI protocol is a diffusion weighted MRI protocol.

In any of the embodiments the multiple MRI pulse sequence parameters may specify any one of the following: multiple diffusion directions, multiple b-values, pulse sequence repetitions, radio-frequency excitations, and combinations thereof, wherein the regrouping of the multiple MRI packages into the interleaved acquisition groups may be performed such that k-space acquisitions from different MRI packages having the same of MRI pulse sequence parameters are grouped together, and wherein at least a portion of the interleaved acquisition group is acquired during a same gating period.

In any of the embodiments the individual acquisitions of the k-space data may be triggered by the periodic physiological signal after an acquisition specific delay.

In any of the embodiments the acquisition of the k-space data in an interleaved fashion is performed such that one slice of the one or more package specific slices has a critical timing restriction for the acquisition specific delay and at least one other of the one or more package specific slices has a non-critical timing restriction.

In some of the embodiments the acquisition specific delay for each of the one or more package specific slices may be optimized.

In any of the embodiments the physiological signal is a cardiac signal. Additionally or alternatively, the periodic physiological signal is a respiratory signal.

In some of the embodiments the physiologically gated MRI protocol is adapted for pediatric MRI imaging.

In any of the embodiments acquisition of the one of the interleaved acquisition groups may be finished before beginning the acquisition of a subsequent one of the interleaved acquisition groups.

In any of the embodiments the regrouping of the multiple MRI packages may be performed by matching one or more of the pulse sequence parameters, wherein the one or more pulse sequence parameters comprise any one of the following: a diffusion direction, a b-value, averages, and combinations thereof.

In any of the embodiments at least one of the multiple MRI packages may be configured for measuring any one of the following: a spinal region, a cardiac region, a liver region, a liver region during a subject breath hold, and a soft tissue region that moves synchronously with the periodic physiological signal.

At least one magnetic resonance image may be reconstructed based on any of the embodiments of the method, and output to a display screen of a peripheral.

In another aspect, a computer program is disclosed, the computer program comprising machine executable instructions, wherein execution of the machine executable instructions causes a computational system to control a magnetic resonance imaging system and to perform a method according to any of the embodiments.

### BRIEF DESCRIPTION OF THE DRAWINGS

In the following preferred embodiments of the invention will be described, by way of example only, and with reference to the drawings in which:
Fig. 1 illustrates an example of a medical system which incorporates a magnetic resonance imaging system.
Fig. 2 shows a flow chart which illustrates a method of using the medical system according to the invention.
Fig. 3 illustrates a cloud base example of a medical system.
Fig. 4 illustrates several magnetic resonance imaging packages.
Fig. 5 shows the magnetic resonance imaging packages regrouped into interleaved acquisition groups according to the invention.
Fig. 6 shows several magnetic resonance images illustrating improvements in image quality by using embodiments of the invention.
Fig. 7 shows several magnetic resonance images which show the benefit of using cardiac trigger in liver magnetic resonance imaging according to the invention.
Fig. 8 shows a survey MRI scan that marks the location of slices which have a critical timing restriction due to proximity to the heart.

### DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may pertain to a method with corresponding features and/or may be implemented in a computer implemented method and/or in a computer program product, in a corresponding manner. Like numbered elements in these figures are either equivalent elements or perform the same function. Elements which have been discussed previously will not necessarily be discussed in later figures if the function is equivalent. In one aspect there is a medical system that comprises a magnetic resonance imaging system. In some instances, the medical system may simply be the magnetic resonance imaging system and possibly the workstations or controllers for the magnetic resonance imaging system. In other examples, the medical system may also additionally comprise distributed computing components. For example, there may be a web-based or internet accessible server or blade which is used to perform image reconstruction. The medical system comprises a memory storing machine executable instructions and pulse sequence commands configured for implementing a physiologically gated MRI protocol. A physiologically gated MRI protocol encompasses a magnetic resonance imaging protocol that is able to be triggered by a physiological signal and thereby control when the MRI data or k-space data is acquired. For example, when a subject breathes or has heart motion this may cause periodic motion and just randomly acquiring k-space data may result in blurred or images with artifacts. The physiologically gated MRI protocol uses gates to a physiological signal to control when data is acquired with respect to a periodic physiological state of the subject.

The medical system further comprises a computational system. Execution of the machine executable instructions causes the computational system to receive multiple MRI packages. Each MRI package is a grouping of multiple MRI pulse sequence parameters each specifying one or more package specific slices. The pulse sequence commands may be used for controlling the magnetic resonance imaging system to acquire k-space data. In the MRI packages the MRI pulse sequence parameters are provided and these are used to adjust or customize the pulse sequence commands to various acquisitions. For example, the slice could be specified as well as various other parameters used in acquiring the k-space data. Execution of the machine executable instructions further causes the computational system to regroup the multiple MRI packages into interleaved acquisition groups such that the one or more package specific slices for any of the multiple MRI packages is not repeated within each of the interleaved acquisition groups. Normally the acquisition of the k-space data is organized through the use of these MRI packages. In this case a particular slice or group of slices is repeatedly imaged for a set of different acquisition parameters. These different acquisition parameters are specified by the MRI pulse sequence parameters. When the acquisition of k-space data is triggered by a periodic physiological signal the same slices are imaged repeatedly over and over again if it is controlled with the MRI packages. This may for example be disadvantageous because the recovery time, for example, T1 or T2 values may be longer than the interval between the periodic physiological signals. This may then result in the acquisition of k-space data which has a reduced or decreased image quality.

Execution of the machine executable instructions further causes the computational system to regroup the multiple MRI packages into interleaved acquisition groups such that the one or more package specific slices for any of the multiple MRI packages is not repeated within each of the interleaved acquisition groups. In this feature, instead of going through and acquiring the k-space data for the same slice or group of package specific slices, the pulse sequence parameters are regrouped so that within a particular interleaved acquisition group the same slice is not repeated twice. This may have the effect of providing for the acquisition of k-space data which provides for superior image quality.

Execution of the machine executable instructions further causes the computational system to repeatedly receive a periodic physiological signal descriptive of a physiological state of a subject. This may for example be a signal which measures the subject's heart signal or a breathing or respiratory state of the subject. Execution of the machine executable instructions further causes the computational system to repeatedly acquire k-space data by controlling the magnetic resonance imaging system with the pulse sequence commands triggered by the periodic physiological signal while sequentially adjusting the pulse sequence commands with the pulse sequence parameters of one of the interleaved acquisition groups. The various interleaved acquisition groups are acquired one-by-one and as was noted above, instead of going through a repeatedly acquiring data from the same slices over and over again within an interleaved acquisition group, the data is only acquired from a particular slice only once. As was mentioned above, this has the effect of greatly increasing the interval time between acquisitions and this gives things such as the T1 relaxation time to recover.

The method further comprises providing the acquired k-space data. The providing of the k-space data may be performed in various ways. In one instance it may be for example stored to a database or associated with a DICOM file. In other examples the acquired k-space data may be provided indirectly by reconstructing one or more magnetic resonance images from the acquired k-space data. In other examples the acquired k-space data may be provided by sending it to a computer or workstation or other computational system that provides for image reconstruction of the acquired k-space data.

In another example the physiologically gated MRI protocol is a diffusion weighted MRI protocol. This example is advantageous because the diffusion weighted MRI protocols are particularly sensitive to motion of the subject's body. For example, respiratory and/or cardiac motion may be enough to cause extreme amounts of noise or artifacts in diffusion weighted magnetic resonance images. This example may provide for a higher quality of diffusion weighted MRI images.

In another example, the multiple MRI pulse sequence parameters specify any one of the following: multiple diffusion directions, multiple b-values, pulse sequence repetitions, radio-frequency excitations and combinations thereof. These values are all typical which are useful for specifying the gross properties of a diffusion weighted magnetic resonance image. The regrouping of the multiple MRI packages into the interleaved acquisition groups is performed such that the k-space acquisitions from different MRI packages having the same MRI pulse sequence parameters are grouped together. For example, images in k-space data from different slices may be grouped together during diffusion weighted imaging if they have compatible pulse sequence parameters. For example, if the diffusion direction is identical in all of the slices and also the b-values, then it may be possible to acquire the k-space data from different slices during the same shot. At least a portion of the interleaved acquisition group is preferably acquired during the same gating period. This example may be beneficial because it may help to accelerate the acquisition of the k-space data and also alleviate or reduce the amount of motion artifacts in some instances.

The b-value in diffusion weighted magnetic resonance imaging (MRI) is a parameter, expressed in units of seconds per square millimeter (s/mm²), that quantifies the degree of diffusion weighting applied during the imaging sequence. It is determined by factors including the strength and duration of the diffusion-sensitizing gradients, and it directly influences the sensitivity of the acquired images to the diffusion of water molecules within tissue.

In several examples herein reference is made to diffusion directions M, P, and S. The designations M, P, and S may refer to the principal diffusion-sensitizing gradient directions aligned with the patient's anatomical axes. Specifically, M generally corresponds to the medial-lateral (or left-right) axis, P to the posterior-anterior axis, and S to the superior-inferior axis. These directional gradients are applied to measure the diffusion of water molecules along distinct spatial orientations, which facilitates the assessment of tissue microstructure and the characterization of anisotropic diffusion properties.

In another example, the machine executable instructions are configured such that the individual acquisitions of the k-space data are triggered by the periodic physiological signal after an acquisition specific delay. The acquisition specific delay may be a delay that is tailored for a particular acquisition of k-space data. For example, as the distance from the heart increases there is a slight delay where the motion of the heart or even the blood pressure increases the delay. For example, if the blood pumps the blood the increase in the blood flow or pressure does not increase automatically throughout the entire body equally. This may also be true for mechanical motion caused by the lung or mechanical motion of the heart. It takes time for these motions to spread through a soft tissue. The acquisition specific delay may then be a delay which is adjusted for a particular slice or slices.

In another example, the acquisition of the k-space data in an interleaved fashion is performed such that one slice of the one or more package slices has a critical timing restriction for the acquisition specific delays and at least one other of the one or more package specific slices has a non-critical timing restriction. An example which illustrates this would be different slices within the liver of a subject. Portions of the liver closer to the heart may have a greater amount of motion than slices further away from the heart. The slices closer to the heart may have a very critical timing restriction because it is more important to have them acquired during the proper phase of the heart motion. One could think then about accelerating the acquisition by grouping this one slice of the liver, which is close to the heart and very tightly controlling when it is acquired so that the heart and the liver are in the proper position and then being less concerned about slices that are further away and are less affected by the motion of the heart. Instead of having a very specific acquisition delay for all the slices, in this example the acquisition specific delay is set precisely for the slices where it matters and then may be relaxed in slices where it is not important or is less important.

In another example, execution of the machine executable instructions causes the computational system to optimize the acquisition specific delay for each of the one or more package specific slices. In this example, when k-space data for a slice is acquired the acquisition specific delay is tightly adjusted for each one of them. This may be good in some situations where it is desired to have tight control over the motion of the tissue with relation to the physiological motion such as the heart or breathing.

In another example, the periodic physiological signal is a cardiac signal. This example may be beneficial because cardiac motion may cause problems when trying to acquire k-space data from a subject. Having the acquired k-space data accurately acquired in the proper motion position may be beneficial. When the periodic physiological signal is a cardiac signal, the method can be extended by having the subject perform a breath hold.

In another example, the periodic physiological signal is a respiratory signal. Likewise, the motion of the subject due to breathing may cause the k-space data to be acquired in different locations if this is not controlled for. Using the respiratory signal to control this may result in magnetic resonance images with fewer motion artifacts.

In another example, the physiologically gated MRI protocol is adapted for pediatric MRI imaging. This may be beneficial particularly for breathing for pediatric patients or subjects. For smaller children the breathing rate tends to be more rapid than for adult subjects or patients. For pediatric patients the motion due to respiratory has a larger effect and may more closely resemble the motion artifacts due to cardiac motion. Adapting breathing for pediatric applications may provide better pediatric magnetic resonance images.

In another example, execution of the machine executable instructions causes the computational system to finish acquisition of one of the interleaved acquisition groups before beginning acquisition of a subsequent one of the interleaved acquisition groups. This may be beneficial because it may provide better control of the relaxation time such as the T1 relaxation time. If the particular interleaved acquisition group is repeatedly acquired and acquired until it is finished, then it is more likely that the various slices have had time to recover their magnetization.

In another example, the regrouping of the multiple MRI package is performed by matching one or more of the pulse sequence parameters. The one or more pulse sequence parameters comprise any one of the following: a diffusion direction, a b-value, averages, and combinations thereof. This may be beneficial because these may be useful in grouping MRI acquisitions which are compatible and may be possibly acquired during the same shot.

In another example, at least one of the multiple MRI packages is configured for measuring any one of the following: a spinal region, a cardiac region, a liver region and a soft tissue region that moves synchronously with the periodic physical signal. All of these regions may be greatly affected by motion of the physiological process that is being measured.

In another example, at least one of the multiple MRI packages is configured for measuring the liver region using cardiac triggering during a breath hold of the subject. This may for example be beneficial because the entire acquisition could be acquired during a breath hold or multiple breath holds. The effect of the subject's breathing could be eliminated as a source of movement during the acquisition of the k-space data.

In another example, execution of the machine executable instructions further causes the computational system to reconstruct at least one magnetic resonance image using the k-space data. This for example may be reconstructed by a local computer or controller of the magnetic resonance imaging system. In other instances, this may be performed in the cloud or may be performed remotely.

In another aspect a method of magnetic resonance imaging is disclosed. The method comprises receiving multiple MRI packages. Each MRI package is a grouping of multiple MRI pulse sequence parameters each specifying one or more package specific slices. The multiple MRI pulse sequence parameters are adapted for configuring pulse sequence commands to implement a physiologically gated MRI protocol. The method further comprises regrouping the multiple MRI packages into interleaved acquisition groups such that the one or more package specific slices for any of the multiple MRI packages is not repeated within each of the interleaved acquisition groups. The method further comprises repeatedly receiving a periodic physiological signal descriptive of a physiological state of a subject. The method further comprises repeatedly acquiring k-space data by controlling the magnetic resonance imaging system and triggered by the periodic physiological signal with the pulse sequence commands while sequentially adjusting the pulse sequence commands with the pulse sequence parameters of one of the interleaved acquisition groups. The method further comprises providing the acquired k-space data. The advantages of this method have been previously discussed.

In another aspect a computer program is disclosed. The computer program comprises machine executable instructions for execution by a computational system. The computer program may for example be a computer program product and/or may be stored on a non-transitory storage medium. Execution of the machine executable instructions causes the computational system to receive multiple MRI packages. Each of the MRI packages is a grouping of multiple MRI pulse sequence parameters each specifying one or more package specific slices. The multiple MRI pulse sequence parameters are adapted for configuring pulse sequence commands for implementing a physiologically gated MRI protocol.

The execution of the machine executable instructions further causes the computational system to regroup the multiple MRI packages into interleaved acquisition groups such that the one or more package specific slices for any of the multiple MRI packages is not repeated within each of the interleaved acquisition groups. Execution of the machine executable instructions further causes the computational system to repeatedly receive a periodic physiological signal descriptive of a physiological state of the subject. Execution of the machine executable instructions further causes the computational system to repeatedly acquire k-space data by controlling the magnetic resonance imaging system triggered by the periodic physiological signal with the pulse sequence commands while sequentially adjusting the pulse sequence commands with the pulse sequence parameters of one of the interleaved acquisition groups. Execution of the machine executable instructions further causes the computational system to provide the acquired k-space data. The advantages of this computer program have been previously discussed.

The periodic physiological signal may be measured by a variety of different types of devices. For example, the subject may have a respiratory belt, an ECG, a heart monitor, a Peripheral Pulse Unit (PPU), or even a camera may observe the respiratory motion of the subject or even a change in the appearance of the color of the subject's face to determine a cardiac signal. In some examples the magnetic resonance imaging system or the medical system may comprise a subject motion monitor which may comprise one of the above mentioned sensors.

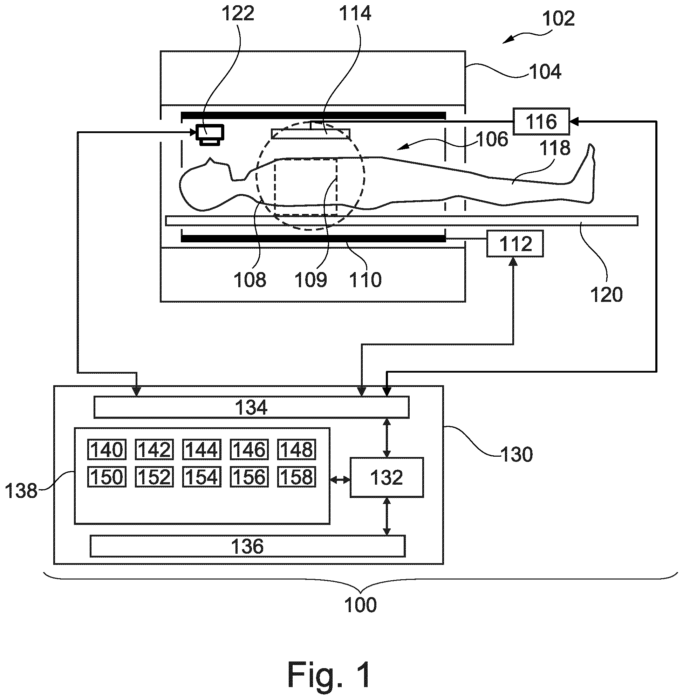

Fig. 1 illustrates an example of a medical system 100 that comprises a magnetic resonance imaging system 102 and a computer 130 or local controller. The magnetic resonance imaging system 102 comprises a magnet 104. The magnet 104 is a superconducting cylindrical type of magnet with a bore 106 through it. It is also possible to use both a split cylindrical magnet and a so-called open magnet. A split cylindrical magnet is similar to a standard cylindrical magnet, except that the cryostat has been split into two sections to allow access to the iso-plane of the magnet. Such magnets may for instance be used in conjunction with charged particle beam therapy. An open magnet has two magnet sections, one above the other with a space in-between that is large enough to receive a subject. The arrangement of the two magnet sections is similar to that of a Helmholtz coil. Open magnets are popular because the subject is less confined. Inside the cryostat of the cylindrical magnet there is a collection of superconducting coils.

Within the bore 106 of the cylindrical magnet 104 there is an imaging zone 108 where the magnetic field is strong and uniform enough to perform magnetic resonance imaging. A field of view 109 is shown within the imaging zone 108. The k-space data are acquired for the field of view 109. The region of interest could be identical with the field of view 109 or it could be a sub volume of the field of view 109. A subject 118 is shown as being supported by a subject support 120 such that at least a portion of the subject 118 is within the imaging zone 108 and the field of view 109.

Within the bore 106 of the magnet there is also a set of magnetic field gradient coils 110 which is used for the acquisition of k-space data to spatially encode magnetic spins within the imaging zone 108 of the magnet 104. The magnetic field gradient coils 110 are connected to a magnetic field gradient coil power supply 112. The magnetic field gradient coils 110 are intended to be representative. Typically, magnetic field gradient coils 110 contain three separate sets of coils for spatial encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio frequency coil 114 for manipulating the orientations of magnetic spins within the imaging zone 108 and for receiving radio transmissions from spins also within the imaging zone 108. The radio frequency antenna may contain multiple coil elements. The radio frequency antenna may also be referred to as a channel or antenna. The radio frequency coil 114 is connected to a radio frequency transceiver 116. The radio frequency coil 114 and radio frequency transceiver 116 may be replaced by separate transmit and receive coils and a separate transmitter and receiver. It is understood that the radio frequency coil 114 and the radio frequency transceiver 116 are representative. The radio frequency coil 114 is intended to also represent a dedicated transmit antenna and a dedicated receive antenna. Likewise, the transceiver 116 may also represent a separate transmitter and receiver. The radio frequency coil 114 may also have multiple receive/transmit elements and the radio frequency transceiver 116 may have multiple receive/transmit channels.

Within the bore of the magnet 106 there is a camera 122 that functions as a subject monitoring device 122 to monitor the cardiac phase of the subject 118. The subject monitoring device 122 could be implemented in different ways for measuring for example respiratory or cardiac signals. There may be an EEG measurement, a respiratory belt, or even the camera observing the subject's 118 chest motion.

The computer 130 is intended to represent one or more computers that are at one or more locations or are distributed. In this particular example the computer 130 is used to locally control the magnetic resonance imaging system 102. The computer 130 comprises a computational system 132. Various computational tasks may be spread to various processors or computational systems 132 located at one or more locations. The computational system 132 is shown as being in communication with a hardware interface 134 that communicates with the magnetic field gradient coil power supply 112, the transceiver 116, and the subject monitoring device 122. The computational system 132 is able to control the magnetic resonance imaging system 102 via the hardware interface 134. The hardware interface 134 may for example be a network connection and may also enable the communication with other computers or computer systems. The computational system may be termed control and/or processing system, whereas both the computing system and the MRI system may also be termed subsystems

The computational system 132 is shown as being in further communication with an optional user interface 136 that may for example enable an operator or user to control the operation and function of the medical system 100, for example by using one or more peripherals. The computational system 132 is in further communication with a memory 138 that is intended to represent various types of memory accessible to the computational system 132. In some examples the memory 138 may be permanent or a non-transitory storage medium. The memory in some embodiments may be based on or may rely on cloud-based data stored in logical pools across disparate, commodity storage servers located on premises or in a data center managed by a third-party cloud provider. Accordingly, the memory as schematically depicted in Fig. 1 is just for illustration purposes. Therefore, any or all components comprised in memory may be cloud-based.

The memory 138 is shown as containing machine executable instructions 140. The machine executable instructions 140 enable the computational system 132 to function and also to control the magnetic resonance imaging system 102. In some instances, the machine executable instructions 140 may contain an operating system as well as various routines and operations which enable numerical and image processing tasks to be performed.

The memory 138 is further shown as containing pulse sequence commands 142 for implementing a physiologically gated MRI protocol. When the magnetic resonance imaging system 102 is controlled with the pulse sequence commands 142 it enables it to acquire k-space data from the field of view 109. The memory 138 is further shown as showing three MRI packages 144, 146, and 148 that have been received. They contain parameters which are used to configure the pulse sequence commands 142 for different acquisitions. In this example, the various MRI packages 144, 146, and 148 contain sets of acquisitions for particular groups of slices. The memory 138 is further shown as containing interleaved acquisition groups 150, 152, 154, and 156 that have been created by rearranging the pulse sequence parameters contained within the MRI packages 144, 146, and 148. This is done by regrouping them so that a particular group of package specific slices are not repeated within the particular interleaved acquisition groups 150, 152, 154, and 156. The memory 138 is further shown as containing multiple groups of k-space data 158 that were acquired by controlling the magnetic resonance imaging system 102 with the interleaved acquisition groups 150, 152, 154, and 156.

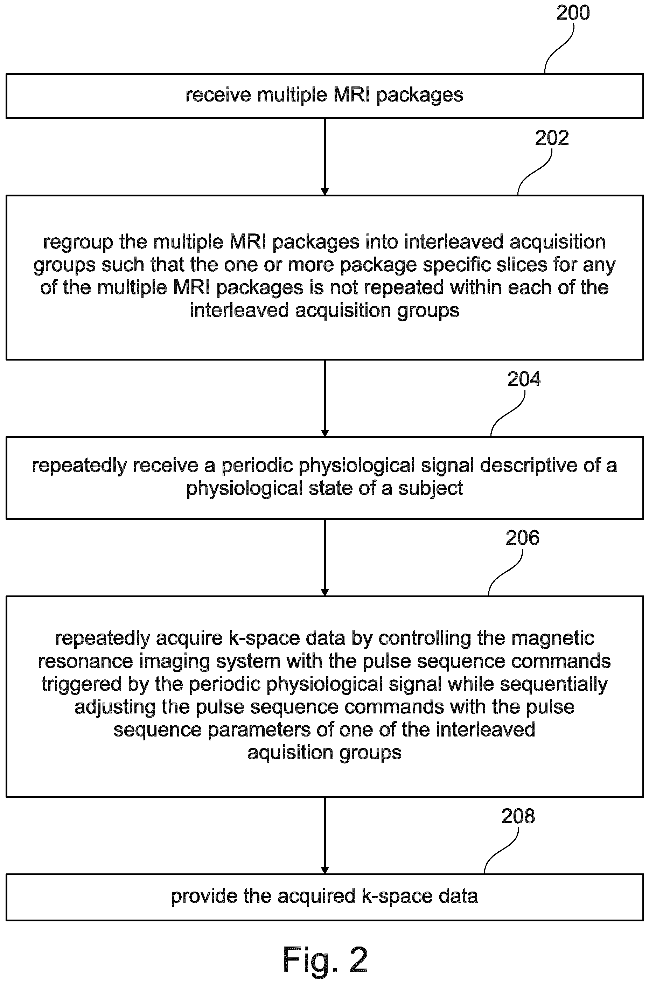

Fig. 2 shows a flowchart, which illustrates a method of operating the medical system. In step 200 the multiple MRI packages 144, 146, and 148 are received. In step 202, the multiple MRI packages 144, 146, and 148 are regrouped into the interleaved acquisition groups 150, 152, 154, and 156 such that the one or more package specific slices for any of the multiple MRI packages 144, 146, and 148 are not repeated within each of the interleaved acquisition groups 150, 152, 154, and 156. In step 204, the periodic physiological signal is received from the subject monitoring device 122. This is used to trigger the individual acquisitions. In step 206, the k-space data is repeatedly acquired by triggering the pulse sequence commands that have been sequentially adjusted with the pulse sequence parameters of the interleaved acquisition groups 150, 152, 154, and 156. In step 208, the acquired k-space data 158 is provided. In further steps the k-space data may be reconstructed into one or more magnetic resonance images.

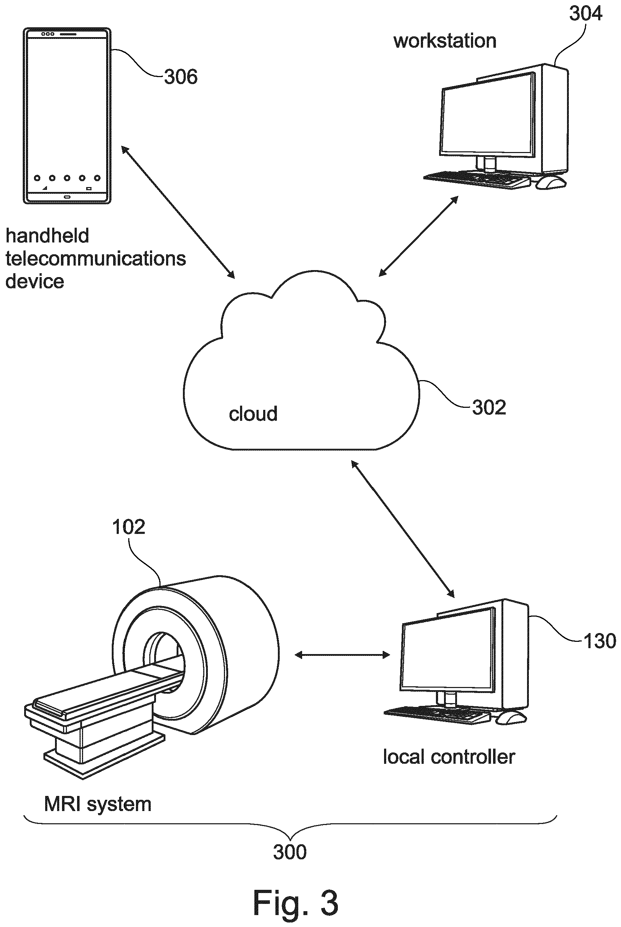

Fig. 3 illustrates a further example of a medical system 300. The medical system 300 is shown as comprising the magnetic resonance imaging system 102 and the local controller or computer 130, as was illustrated in Fig. 1. The medical system 300 is further shown as comprising a cloud computing system 302 that may be connected to additional computing devices such as a workstation 304 and a handheld telecommunications device 306. In this example, the k-space data 158 could for example be sent to the cloud computing system 302 to be processed into magnetic resonance images. These images could then for example be shared back with the operator at the local controller 130 using the user interface 136 or they could be displayed by the handheld telecommunications device 306 or the workstation 304. For example, the handheld telecommunications device 306 may have an app or program which enables a radiologist or other healthcare provider to examine the magnetic resonance images after they have been acquired using the magnetic resonance imaging system 102. Likewise, the workstation 304 may for example be a workstation or computer located in a radiology department or by another healthcare provider and may enable the healthcare provider to examine or see the resulting magnetic resonance images.

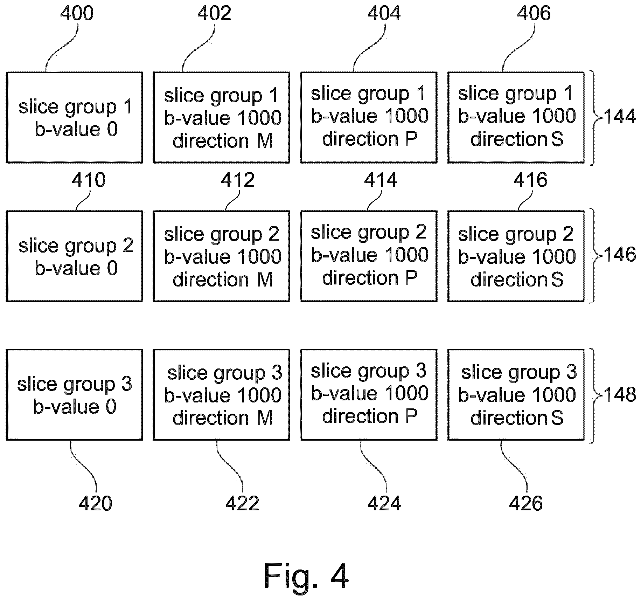

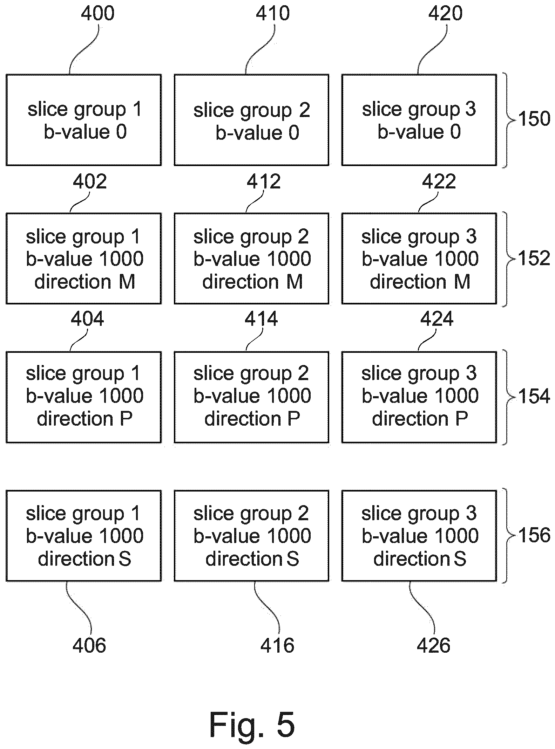

Figs. 4 and 5 are used to illustrate the regrouping process. Fig. 4 shows MRI package A 144, MRI package B 146, and MRI package C 148. MRI package A 144 has a number of pulse sequence parameters 400, 402, 404, and 406 that are grouped together. These pulse sequence parameters are all for a first slice group or slice group 1. Slice group 1 comprises one or more slices used for acquiring k-space data. Pulse sequence parameters 400 are for slice group 1 and have a b-value of 0. Pulse sequence parameters 402 are also for slice group 1 and have a b-value of 1000 in direction M. Pulse sequence parameters 404 have slice group 1 with a b-value of 1000 in direction P. Pulse sequence parameters 406 are for slice group 1 and have a b-value of 1000 in direction S.

Likewise, MRI package B 146 is for a second slice group. The slices in slice group 2 are distinct from the slices in slice group 1. In MRI package B 146, there are pulse sequence parameters 410 which are for slice group 2 and have a b-value of 0. In this group there are also pulse sequence parameters 412 for slice group 2 with a b-value of 1000 in direction M. Also in this group are pulse sequence parameters 414 with slice group 2 having a b-value of 1000 in direction P. Pulse sequence parameters 416 have slice group 2 with a b-value of 1000 in direction S.

MRI package C 148 comprises pulse sequence parameters 420, 422, 424, and 426. The slices in slice group 3 are distinct from the slices in slice group 2 and slice group 1. The pulse sequence parameters 420 also have a b-value of 0. Pulse sequence parameters 422 are for slice group 3 with a b-value of 1000 in direction M. Pulse sequence parameters 424 are for slice group 3 with a b-value of 1000 in direction P. Pulse sequence parameters 426 have slice group 3 with a b-value of 1000 in direction S.

Fig. 5 shows interleaved acquisition group 1 denoted with 150, interleaved acquisition group 2 denoted with 152, interleaved acquisition group 3 denoted with 154, interleaved acquisition group 4 denoted with 156. Within interleaved acquisition group 1 are pulse sequence parameters 400, 410, and 420. Within interleaved acquisition group 2 are pulse sequence parameters 402, 412, and 422. Within interleaved acquisition group 3 are pulse sequence parameters 404, 414, and 424. Within interleaved acquisition group 4 are pulse sequence parameters 406, 416, and 426. Examining these, it can be seen that within the interleaved acquisition groups 150, 152, 154, and 156 the slice groups are not repeated within the same interleaved acquisition group. This increases the time when the various slices are excited and results in a higher pulse repetition time. As was mentioned, this provides for sufficient regrowth of the longitudinal magnetization and results in a higher quality magnetic resonance image.

In other words, in one example, when each of the slice groups comprises a single slice, then according to Fig. 4 this particular exemplification contains three slices, two b-values (e.g., b0 and b1000) and three directions for b1000 (e.g., M, P, S). For M2D normally one slice per trigger is acquired for which for a single slice b0 is followed by b1000M, b1000P and b1000S. When interleaving according to Fig. 5, the order in time changes to b0 slice 1, b0 slice 2, b0 slice 3, b1000M slice 1, b1000P, etc.

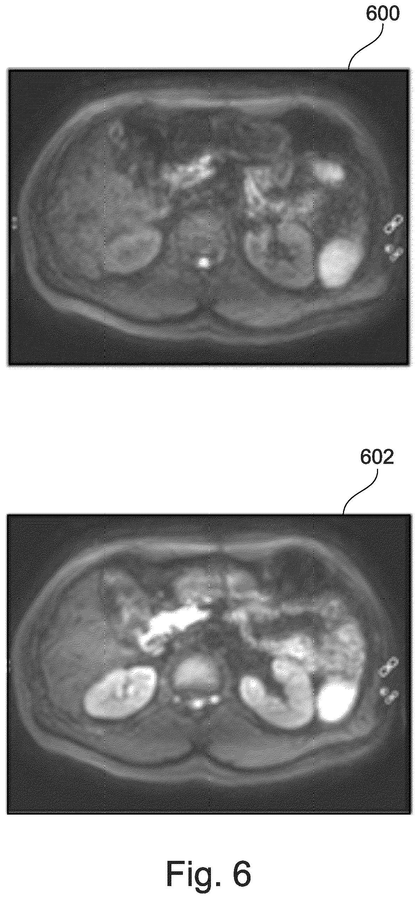

Fig. 6 shows two magnetic resonance images. Magnetic resonance image 600 was acquired using the MRI packages 144, 146, and 148. Magnetic resonance image 602 was acquired using the interleaved acquisition groups 150, 152, 154, and 156. These two images 600 and 602 are for a single slice out of all these acquisitions and are isotropic b1000 images, which is the summation of b1000M, b1000P and b1000S. Comparing images 600 and 602, it can be seen that the quality of magnetic resonance image 602 is much higher. The pulse repetition time was increased by a factor of 5 allowing for the longitudinal magnetization to recover more fully.

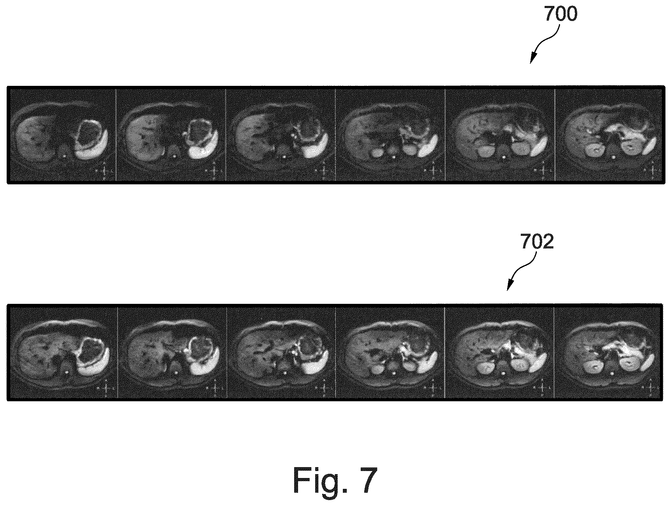

Fig. 7 illustrates a series of images for abdominal diffusion weighted imaging. In the top row 700 are a number of non-cardiac triggered slices. The bottom row images 702 represent images that were triggered using cardiac triggering. The bottom row of images 702 do not suffer from the signal loss in the left liver lobe. Abdominal MRI often suffers from signal loss, especially in the left liver lobe, due to cardiac motion. Cardiac triggering helps to apply the diffusion gradients during the stable phase of the heart avoiding the encoding of motion as result of the beating heart. Acquisition in normal M2D/multi-slice mode results in short repetition times, as already indicated; 1 second for a cardiac frequency of 60 beats/minute. This is far shorter than the advised TR (pulse sequence repetition) of over 3 seconds for sufficient regrowth of longitudinal magnetization. Interleaving may increase the TR without loss of scan time, which normally is the case when a TR of 3 beats would need to be chosen. This extends the scan time enormously, which is time consuming in daily routine in case only a single slice is acquired per heartbeat. Scan times are already easily 10 minutes and even longer for low cardiac frequencies. Here, trigger delay optimization comes into the picture. Aligning the optimal trigger delay with the sequence timings, may allow the acquisition of multiple slices per heartbeat. Even if only 2 slices fit per trigger, already a scan time gain of a factor of 2 is realized. Next to the scan time gain, an optimized trigger delay per slice will improve image quality.

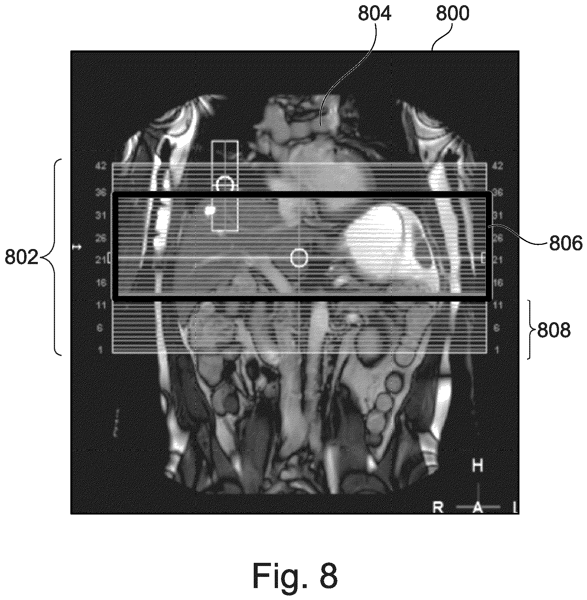

Fig. 8 shows a survey or planning magnetic resonance image 800. Image 800 shows a coronal slice of the subject. The lines 802 indicate the location of possible transverse slices. The subject's heart 804 is also visible. The slices 802 may be used to image the subject's liver. However, the slices marked by the box 806 are adjacent to the heart and therefore experience motion during the cardiac cycle. The slices 806 therefore have a critical timing restriction. In Fig. 7 the images 700 were acquired without cardiac triggering. The images 702 were acquired with cardiac triggering. The slices shown in Fig. 7 correspond to the region 806 as illustrated in Fig. 8. The slices 808 are less affected by cardiac motion and therefore may have a non-critical timing restriction.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit", "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electromagnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational systems to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the C programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, WLAN connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, television screen, touch screen, tactile electronic display, Braille screen, Cathode Ray Tube (CRT), storage tube, bi-stable display, electronic paper, vector display, flat panel display, Vacuum Fluorescent (VD) display, Light-Emitting Diode (LED) displays, Electro-Luminescent Display (ELD), Plasma Display Panels (PDP), Liquid Crystal Display (LCD), Organic Light-Emitting Diode (OLED) displays, a projector, and head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A medical system (100, 300) comprising a magnetic resonance imaging, MRI, system (102), wherein the medical system comprises:
a memory (138) storing machine executable instructions (140) and pulse sequence commands (142) configured for implementing a physiologically gated MRI protocol;
a computational system (132), wherein execution of the machine executable instructions causes the computational system to:
receive (200) multiple MRI packages (144, 146, 148), wherein each MRI package is a grouping of multiple MRI pulse sequence parameters (400, 402, 404, 406, 410, 412, 414, 416, 420, 422, 424, 426) each specifying one or more package specific slices;
regroup (202) the multiple MRI packages into interleaved acquisition groups (150, 152, 154, 156) such that the one or more package specific slices for any of the multiple MRI packages is not repeated within each of the interleaved acquisition groups;
repeatedly (204) receive a periodic physiological signal descriptive of a physiological state of a subject (118);
repeatedly (206) acquire k-space data (158) by controlling the magnetic resonance imaging system with the pulse sequence commands triggered by the periodic physiological signal while sequentially adjusting the pulse sequence commands with the pulse sequence parameters of one of the interleaved acquisition groups; and
provide (208) the acquired k-space data.

2. The medical system of claim 1, wherein the physiologically gated MRI protocol is a diffusion weighted MRI protocol.

3. The medical system of claim 2, wherein the multiple MRI pulse sequence parameters specify any one of the following: multiple diffusion directions, multiple b-values, pulse sequence repetitions, radio-frequency excitations, and combinations thereof, wherein the regrouping of the multiple MRI packages into the interleaved acquisition groups is performed such that k-space acquisitions from different MRI packages having the same of MRI pulse sequence parameters are grouped together, and wherein at least a portion of the interleaved acquisition group is acquired during a same gating period.

4. The medical system of claim 3, wherein the machine executable instructions are configured such that that individual acquisitions of the k-space data are triggered by the periodic physiological signal after an acquisition specific delay.

5. The medical system of claim 4, wherein acquisition of the k-space data in an interleaved fashion is performed such that one slice of the one or more package specific slices has a critical timing restriction for the acquisition specific delay and at least one other of the one or more package specific slices has a non-critical timing restriction.

6. The medical system of claim 4 or 5, wherein execution of the machine executable instructions causes the computational system to optimize the acquisition specific delay for each of the one or more package specific slices.

7. The medical system of any one of the preceding claims, wherein the periodic physiological signal is a cardiac signal.

8. The medical system of any one of claims 1 to 5, wherein the periodic physiological signal is a respiratory signal.

9. The medical system of claim 8, wherein the physiologically gated MRI protocol is adapted for pediatric MRI imaging.

10. The medical system of any one of the preceding claims, wherein execution of the machine executable instructions causes the computational system to finish acquisition of the one of the interleaved acquisition groups before beginning acquisition of a subsequent one of the interleaved acquisition groups.

11. The medical system of any one of the preceding claims, wherein the regrouping of the multiple MRI packages is performed by matching one or more of the pulse sequence parameters, wherein the one or more pulse sequence parameters comprise any one of the following: a diffusion direction, a b-value, averages, and combinations thereof.

12. The medical system of any one of the preceding claims, wherein at least one of the multiple MRI packages is configured for measuring any one of the following: a spinal region, a cardiac region, a liver region, a liver region during a subject breath hold, and a soft tissue region that moves synchronously with the periodic physiological signal.

13. The medical system of any one of the preceding claims, wherein execution of the machine executable instructions further causes the computational system to reconstruct at least one magnetic resonance image using the acquired k-space data.

14. A method of magnetic resonance imaging, MRI, comprising:
receiving (200) multiple MRI packages (144, 146, 148), wherein each MRI package is a grouping of multiple MRI pulse sequence parameters (400, 402, 404, 406, 410, 412, 414, 416, 420, 422, 424, 426) each specifying one or more package specific slices, wherein the multiple MRI pulse sequence parameters are adapted for configuring pulse sequence commands for implementing a physiologically gated MRI protocol;
regrouping (202) the multiple MRI packages into interleaved acquisition groups (150, 152, 154, 156) such that the one or more package specific slices for any of the multiple MRI packages is not repeated within each of the interleaved acquisition groups;
repeatedly (204) receiving a periodic physiological signal descriptive of a physiological state of a subject;
repeatedly (206) acquiring k-space data (158) by controlling the magnetic resonance imaging system with the pulse sequence commands triggered by the periodic physiological signal while sequentially adjusting the pulse sequence commands with the pulse sequence parameters of one of the interleaved acquisition groups; and
providing (208) the acquired k-space data.

15. A computer program comprising machine executable instructions (140) for execution by a computational system, wherein execution of the machine executable instructions causes the computational system to:
receive (200) multiple MRI packages (144, 146, 148), wherein each MRI package is a grouping of multiple MRI pulse sequence parameters (400, 402, 404, 406, 410, 412, 414, 416, 420, 422, 424, 426) each specifying one or more package specific slices, wherein the multiple MRI pulse sequence parameters are adapted for configuring pulse sequence commands for implementing a physiologically gated MRI protocol;
regroup (202) the multiple MRI packages into interleaved acquisition groups (150, 152, 154, 156) such that the one or more package specific slices for any of the multiple MRI packages is not repeated within each of the interleaved acquisition groups;
repeatedly (204) receive a periodic physiological signal descriptive of a physiological state of a subject;
repeatedly (206) acquire k-space data (158) by controlling the magnetic resonance imaging system with the pulse sequence commands triggered by the periodic physiological signal while sequentially adjusting the pulse sequence commands with the pulse sequence parameters of one of the interleaved acquisition groups; and
provide (208) the acquired k-space data.
